Europäisches Patentamt

European Patent Office

Office européen des brevets

(11) Veröffentlichungsnummer: **0 494 342 A1**

# (12) EUROPÄISCHE PATENTANMELDUNG

(21) Anmeldenummer: **91115165.2**

(22) Anmeldetag: **07.09.91**

(51) Int. Cl.5: **H01J 37/34**

(30) Priorität: **08.01.91 DE 4100291**

(43) Veröffentlichungstag der Anmeldung:
**15.07.92 Patentblatt 92/29**

(84) Benannte Vertragsstaaten:
**CH DE FR GB LI**

(71) Anmelder: **LEYBOLD AKTIENGESELLSCHAFT**
**Wilhelm-Rohn-Strasse 25, Postfach 1555**
**W-6450 Hanau am Main 1(DE)**

(72) Erfinder: **Maass, Wolfram, Dr.**
**Fröbelstrasse 2**
**W-6455 Erlensee(DE)**
Erfinder: **Cord, Bernhard, Dr.**
**Freigerichter Strasse 33**
**W-8755 Alzenau(DE)**

(74) Vertreter: **Sartorius, Peter, Dipl.-Ing.**
**Patentanwalt**
**Elisabethenstrasse 24**
**W-6803 Edingen-Neckarhausen 2(DE)**

(54) **Zerstäubungskathode.**

(57) Die Erfindung bezieht sich auf eine Zerstäubungskathode 1 nach dem Magnetron-Prinzip, bestehend aus einem mindestens einteiligen Target 11 und einem hinter dem Target 11 angeordneten Magnetsystem mit mehreren ineinanderliegenden und in sich geschlossenen Magneteinheiten 14,15,16 abwechselnd unterschiedlicher Polung, durch die mindestens zwei gleichfalls in sich geschlossene, ineinanderliegende, magnetische Tunnel aus bogenförmig gekrümmten Feldlinien gebildet werden. Die magnetische Feldstärke eines dieser magnetischen Tunnel ist relativ zu der magnetischen Feldstärke des oder der übrigen magnetischen Tunnel über Verschieben eines der Jochteile 17b relativ zu den anderen Jochteilen über eine Verstelleinrichtung 21 veränderbar. Dieses Verstellen der Magneteinheiten bewirkt eine Änderung der Schichtdickenhomogenität der beim Sputtern erzeugten Schichten. Die Verstelleinrichtung ist über einen elektrischen Schaltkreis 32,33,34 ansteuerbar, der mit akustischen Sensoren 28a,28b zusammenwirkt, die auf die Erosionsgräben 36 ausgerichtet sind und die dort während des Sputterns erzeugten Ultraschallwellen registrieren. Die gewonnenen Meßsignale liefern eine eindeutige Information bezüglich der Sputterraten in den einzelnen Erosionsgräben 36 und damit auch über die Schichtdickenhomogenität des gerade zu beschichtenden Substrats, so daß mit Hilfe eines Regelkreises (10,14, 28,32,33,34) eine optimale Homogenität der Schichtdicke sichergestellt wird.

Fig. 1

Die Erfindung betrifft eine Zerstäubungskathode nach dem Magnetron-Prinzip bestehend aus einem mindestens einteiligen Target und einem hinter dem Target angeordneten Magnetsystem mit mehreren ineinanderliegenden und in sich geschlossenen Magneteinheiten abwechselnd unterschiedlicher Polung, durch die mindestens zwei gleichfalls in sich geschlossene, ineinanderliegende magnetische Tunnel aus bogenförmig gekrümmten Feldlinien gebildet werden, wobei die dem Target abgekehrten Pole der Magneteinheiten über ein Magnetjoch miteinander verbunden sind und die magnetische Feldstärke mindestens eines dieser magnetischen Tunnel relativ zu der magnetischen Feldstärke des oder der übrigen magnetischen Tunnel über Verschieben eines der Jochteile in Bezug auf die anderen Jochteile über eine Verstelleinrichtung veränderbar ist.

Durch die DE-OS 34 42 206 ist eine Zerstäubungskathode der eingangs beschriebenen Gattung bekannt, die für die Zerstäubung von Targets aus ferromagnetischen Werkstoffen vorgesehen ist. Bei einem der beiden Ausführungsbeispiele werden durch zwei konzentrisch ineinanderliegende Magneteinheiten in Verbindung mit zwei konzentrischen, in dem Target angeordneten Luftspalten zwei in sich geschlossene, ineinanderliegende magnetische Tunnel aus bogenförmig gekrümmten Feldlinien gebildet. Da aber hierbei die magnetischen Felder über die beiden Luftspalte magnetisch in Reihe geschaltet sind, lassen sich die Feldstärken der beiden Tunnel nicht unabhängig voneinander beeinflussen. Dadurch entstehen im Bereich der beiden magnetischen Tunnel voneinander verschiedene Zerstäubungsraten und im Bereich des dem Target gegenüberliegenden Substrats auch sehr unterschiedliche Niederschlagsraten, so daß die Schichtdickenverteilung sehr ungleichförmig ist.

Durch die DE-OS 22 43 708 ist es bekannt, bei Stabkathoden Magneteinheiten in axialer Richtung hintereinander anzuordnen, um dadurch die Zerstäubung des Targetmaterials zu vergleichmäßigen. Auch für die dort beschriebenen planaren Targets wird angegeben, daß man konzentrische, ineinanderliegende Magneteinheiten und mehrere konzentrisch ineinanderliegende magnetische Tunnel vorsehen kann. Eine getrennte Einstellung eines jeden magnetischen Tunnel unabhängig vom jeweils benachbarten Tunnel ist nicht vorgesehen und auch nicht möglich.

Durch eine unter der Bezeichnung "Con Mag" von der Firma Varian vertriebene Zerstäubungskathode der eingangs beschriebenen Anordnung ist es weiterhin bekannt, innerhalb einer kreisringförmigen Jochplatte mit Abstand eine kreisscheibenförmige Jochplatte vorzusehen und jeder Jochplatte zwei unabhängig voneinander wirkende, entgegengesetzt gepolte Magneteinheiten zuzuordnen, wobei über dem kreisringförmigen Magnetsystem ein Target mit einer kegelförmigen Zerstäubungsfläche und über dem kreisscheibenförmigen Magnetsystem eine ebene Targetplatte angeordnet ist. Mittel für die Beeinflussung der Magnetfeldstärke der zwei gebildeten Tunnel unabhängig voneinander sind nicht vorgesehen. Auch bei dieser Zerstäubungskathode muß der Zerstäubungseffekt so in Kauf genommen werden, wie er durch die relative Lage der magnetischen Tunnel zu den Zerstäubungsflächen vorgegeben ist.

Die weiter oben beschriebene Zerstäubungskathode "Con Mag" der Firma Varian entspringt dem Versuch, die Schichtdickenverteilung zu verbessern, indem man nicht nur die Magnetsysteme, sondern auch die zugehörigen Targetteile elektrisch völlig entkoppelt hat. Dies setzt jedoch den Einsatz von zwei Stromquellen pro Zerstäubungskathode voraus, weiterhin auch eine elektrische Isolation der Target- bzw. Kathodenteile voneinander. Für die Zerstäubung von Targets aus ferromagnetischen Werkstoffen ist ein solches System nicht geeignet.

Außerdem wurde bereits eine Zerstäubungskathode nach dem Magnetron-Prinzip vorgeschlagen (P 36 24 150.4), bestehend aus einem mindestens einteiligen Target und einem hinter dem Target angeordneten Magnetsystem mit mehreren ineinanderliegenden und in sich geschlossenen Magneteinheiten abwechselnd unterschiedlicher Polung, durch die mindestens zwei gleichfalls in sich geschlossene ineinanderliegende magnetische Tunnel aus bogenförmig gekrümmten Feldlinien gebildet werden, wobei die dem Target abgekehrten Pole der Magneteinheiten über ein Magnetjoch miteinander verbunden sind und die magnetische Feldstärke mindestens eines, einen magnetischen Tunnel bildenden Magnetfeldes relativ zu der magnetischen Feldstärke mindestens eines weiteren, einen weiteren magnetischen Tunnel bildenden Magnetfeldes durch Verschieben einer Magneteinheit veränderbar ist. Mit dieser Zerstäubungskathode läßt sich im Prinzip die Schichtdicken-Gleichmäßigkeit auf dem Substrat jederzeit, auch unabhängig vom Targetalter, einstellen. Eine Kontrolle der Zerstäubungsraten beider Plasmaringe während der Herstellung einer Schicht (in situ), wie sie für den Aufbau eines Regelkreises nötig ist, ist nicht möglich. Diese Einschränkung gilt vor allem im Fall von Produktionsmaschinen, in denen die Beschichtungsvorgänge mit kurzen Taktzeiten zyklisch vorgenommen werden.

Schließlich ist eine Zerstäubungskathode der eingangs aufgeführten Art bekannt (DE 38 12 379), die nach dem Magnetronprinzip arbeitet und bei der hinter dem Target ein Magnetsystem mit mehreren, ineinanderliegenden und in sich geschlossenen Magneteinheiten mit abwechselnder Polung liegt. Die dem Target abgekehrten Pole der Magneteinheiten sind über ein Magnetjoch miteinander verbunden. Unterhalb des Targets ist ein optischer Sensor am Gehäuse der Beschichtungskammer ortsfest angeordnet. Wird nun in die Beschichtungskammer Argon-Gas eingelassen und steht dabei die Kathode unter Spannung, dann bilden sich zwei Plasmaringe im Bereich der magnetischen Tunnel aus. Da die Helligkeit der Plasmaringe von der Gesamtleistung der Kathode und der Stellung der Permanentmagnete zueinander abhängig ist, ermöglicht die Messung der Helligkeit eines Plasmarings Rückschlüsse auf die Gleichförmigkeit der Beschichtung. Die von diesem Sensor gewonnenen Informationen ermöglichen den Aufbau eines Regelkreises, der es insbesondere auch erlaubt, die durch den Abtrag des Targets verursachten Veränderungen der Ratenverteilung zu kompensieren. Die Helligkeit des Plasmas hängt jedoch nicht von der Sputterrate allein ab, sondern z.B. auch vom Gasdruck, oder von Beimischungen im Sputtergas, so daß Informationen von dem Sensor erfaßt werden, die die Funktion des Regelkreises stark beeinträchtigen. Derartige Informationen zu eliminieren ist sehr aufwendig und teuer.

Es ist bekannt (Microelectronic Manufactoring and Testing, Nov. 1985, Seite 32 bis 33), daß beim Sputtern Ultraschallwellen erzeugt werden, die mit einem Sensor gemessen werden können. Mit der in MMT beschriebenen Meßanordnung läßt sich allerdings lediglich die Gesamtleistung der Sputterkathode messen, wobei keine Aussagen über lokale Sputterraten auf dem Target möglich sind.

Der vorliegenden Erfindung liegt die Aufgabe zugrunde, den oder die Sensoren derart auszubilden und anzuordnen, daß die Sputterrate der einzelnen Erosionsgräben möglichst genau und direkt bestimmt werden kann, so daß Störeinflüsse wie Schwankung des Prozessgasdrucks oder der Zusammensetzung ausgeschlossen werden. Darüberhinaus soll dieses Meßprinzip eine automatische Kontrolle der Ratenverteilung sicherstellen.

Die Aufgabe wird erfindungsgemäß dadurch gelöst, daß die Verstelleinrichtung über einen elektrischen Schaltkreis ansteuerbar ist, der mit mindestens einem akustischen Sensor zusammenwirkt, der auf mindestens einen der sich beim Beschichtungsvorgang einstellenden Plasmaringe ausgerichtet ist und auf die beim und durch das Sputtern erzeugten Ultraschallwellen anspricht, die nach Auswertung in einem Rechner der Verstelleinrichtung als Stellgröße zur Verfügung stehen. Vorteilhaft ist es, wenn mindestens drei ineinanderliegende Magneteinheiten vorgesehen sind. In vorteilhafter Weise mißt der Sensor die Intensität des Ultraschalls, der durch den Ioneneinschlag auf das Target im Bereich des betreffenden Plasmarings erzeugt wird. Bei dieser Messung haben andere Parameter, wie z.B. Druck, Temperatur und Beimischungen zum Sputtergas keinen Einfluß auf das Meßergebnis. Mit der erfindungsgemäßen Meßvorrichtung wird bei entsprechender Kalibrierung die Sputterrate direkt an dem betreffenden Erosionsgraben des Targets erfaßt.

Umgekehrt ist es möglich, aus der totalen Aufnahme an elektrischer Leistung der Sputterkathode die totale Sputterrate zu bestimmen. Aus der Differenz zwischen direkt gemessener Sputterrate des einen (z.B äußeren) Plasmarings und der indirekt bestimmten Gesamtsputterrate ergibt sich ein Ratenverhältnis R zwischen innerem und äußerem Plasmaring, das in direktem Zusammenhang mit der Ratenverteilung auf dem zu beschichtenden Substrat steht.

Einer maximal möglichen Homogenität der Schichtdicke entspricht ein bestimmter Wert $R_{Soll}$. Eine Abweichung $E = R - R_{Soll}$ zwischen der aus der Messung bestimmten Größe R und diesem Sollwert wird einem Regler zugeführt, der über die Verstelleinrichtung eine Verstellung der Magnete bewirkt, bis die Regelabweichung kompensiert ist. Abweichungen E zwischen dem vorgegebenen Patentverhältnis $R_{Soll}$ und dem gemessenen Verhältnis R entstehen vor allem während der Alterung des Targets, bei der die Erosionsgräben immer tiefer werden. Die hiermit verbundene Änderung der Schichtdickenhomogenität wird durch den Regelkreis kompensiert.

Im Fall des Doppelringsystems kann es nötig sein, daß mit zwei akustischen Sensoren gearbeitet wird, da physikalisch bedingt auch ein sehr exakt auf einen Erosionsgraben ausgerichteter akustischer Sensor Signalanteile des zweiten Erosionsgrabens aufnimmt. Bei Verwendung von zwei Sensoren und unter Verwendung der totalen Sputterrate lassen sich die verschiedenen Signalanteile wieder trennen. Auch in diesem Fall ergibt sich schließlich ein gemessenes Verhältnis R zwischen den Sputterraten der einzelnen Plasmaringe. Die Regelabweichung $E = R - R_{Soll}$ kann, wie oben beschrieben, einem Regelkreis zugeführt werden, der über die Verstellung des Magnetsystems eine optimale Schichtdickenhomogenität sichert.

Das Problem der Signaltrennung des Ultraschalls aus den beiden Erosionsgräben läßt sich auch dadurch lösen, daß einzelne Schallereignisse an unterschiedlichen Meßpositionen vermessen werden und deren Koinzidenz und Quellposition mit Hilfe von Laufzeitbestimmungen ermittelt werden.

Eine andere Weiterbildung der erfindungsgemäßen Vorrichtung gemäß den Unteransprüchen 2 bis 7 besteht darin, die jeweils gemessenen akustischen Signale nur in einen gewissen Bereich des akustischen Spektrums zu vermessen, in dem einerseits der durch den Ioneneinschlag erzeugte Ultraschall besonders stark ist und andererseits störende Fremdquellen wenig Einfluß haben.

Außerdem ist es gemäß Anspruch 8 vorteilhaft, die beschriebene Bestimmung des Ratenverhältnisses R mit Hilfe eines digitalen Rechners vorzunehmen, der auch die Weiterverarbeitung des Signals und die Regelung im Regelkreis übernimmt. Mit diesem digitalen Rechner erfolgt auch die Ansteuerung der Verstelleinrichtung, die z.B. mit einem Schrittmotor ausgestattet sein kann, der seinerseits über eine Spindel die Verschiebung der entsprechenden Magneteinheit übernimmt.

Vorteilhaft ist es ferner, daß die beschriebene Methode zur Messung der lokalen Sputterraten auf dem Target mittels Ultraschallsensoren auch im Fall von mehr als zwei Plasmaringen angewendet werden kann. Die Trennung der Signale, die von den einzelnen Erosionsgräben ausgehen, erfolgt dabei analogerweise wie oben beschrieben.

In weiterer Ausgestaltung der Erfindung ist es vorteilhaft, Ratenverteilungen beim Magnetronsputtern durch lokale Messung vom am Target erzeugten Ultraschall zu messen und über einen Regelkreis durch Verstellen von Magneteinheiten einzustellen. Die Erfindung ist nicht auf den Fall von rotationssymmetrischen Magneton-Sputterkathoden beschränkt sondern bezieht sich auch auf andere Formen von Sputterkathoden. Sie bezieht sich ebenfalls auf andere Ausgestaltungen von Magnetsystemen, bei denen durch ein Verstellen von Teilen des Magnetsystems die Ratenverteilung beeinflußt werden kann.

Gemäß Anspruch 10 ist es auch vorteilhaft, zwei oder mehr Sensoren vorzusehen.

Weitere Merkmale der Erfindung sind in den Unteransprüchen sowie in der Beschreibung und in den Figuren dargestellt, wobei bemerkt wird, daß alle Einzelmerkmale und alle Kombinationen von Einzelmerkmalen erfindungswesentlich sind.

In den Figuren ist die Erfindung an einer Ausführungsform beispielsweise dargestellt, ohne auf diese Ausführungsform beschränkt zu sein. Es zeigt:

Figur 1     einen Schnitt quer durch eine Zerstäubungskathode mit einer verschiebbaren Magneteinheit,

Figur 2     die Draufsicht auf ein kreisscheibenförmiges Target mit zwei Erosionsgräben,

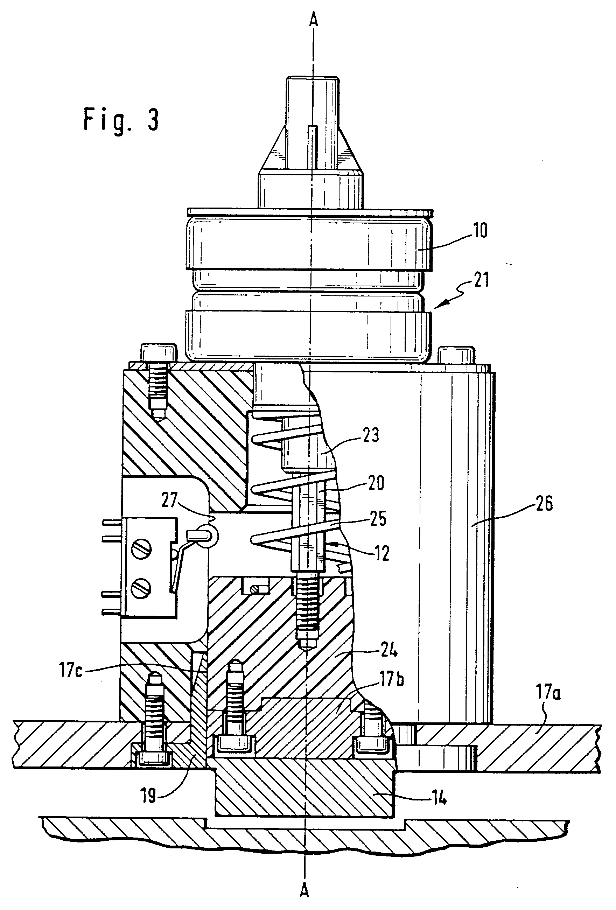

Figur 3     den Querschnitt durch die Verstelleinrichtung der Zerstäubungskathode gemäß Figur 1 in vergrößerter Darstellung,

Figur 4     das Schaltschema der Ansteuereinrichtung der Verstelleinrichtung,

Figur 5     das Target nach mehreren Betriebsstunden.

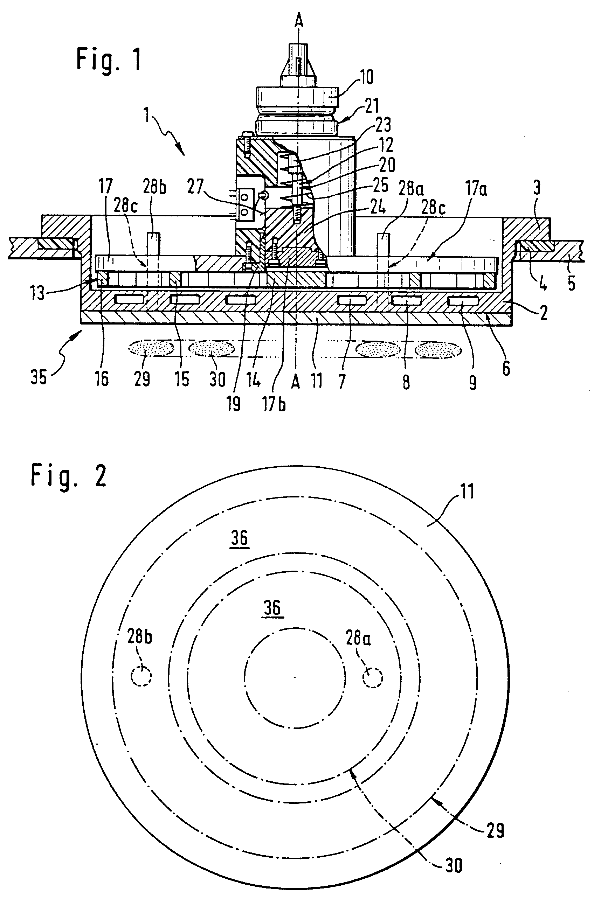

In Figur 1 ist eine Zerstäubungskathode 1 dargestellt, deren tragender Teil ein topfförmiger, hohler Grundkörper 2 ist, der wegen der thermischen Belastung aus einem gut wärmeleitenden Werkstoff, beispielsweise Kupfer, bestehen kann und mittels eines umlaufenden Flansches 3 unter Zwischenschaltung eines Isolierstoffkörpers 4 in eine Wand 5 einer Vakuumkammer 35 eingesetzt ist.

Der topfförmige Grundkörper 2 besitzt eine ebene Stirnplatte 6. Auf der Innenseite der Stirnplatte 6 befinden sich drei konzentrische Kühlwasserkanäle 7,8,9. Auf der Außenseite der Stirnplatte 6 ist durch Bonden ein Target 11 befestigt. In der hinteren Öffnung des Grundkörpers 2 befindet sich ein Magnetsystem 13 mit mehreren Magneteinheiten 14,15,16, die in bezug auf die Achse A-A ineinander liegen, sämtlich aus permanentmagnetischem Material bestehen und in axialer Richtung magnetisiert sind. Die zentrale Magneteinheit 14 hat dabei die Form eines gedrungenen Zylinders. Die Magneteinheiten 15,16 sind dabei aus mehreren quaderförmigen Permamentmagneten zusammengesetzt, deren Polflächen gleicher Polung jeweils im wesentlichen in einer Kreisringfläche liegen. Hierbei ist vernachlässigt, daß eine solche Aneinanderreihung von Permanentmagneten in Wirklichkeit zu einem vieleckigen Polygon führt. Die dem Target 11 abgekehrten Pole der Magneteinheiten 14,15,16 sind über ein Magnetjoch 17 aus weichmagnetischem Material in der in Figur 1 gezeigten Weise miteinander verbunden. Das Magnetjoch 17 besteht dabei aus einem äußeren Jochteil 17a, dessen Grundfläche kreisförmig ausgebildet ist, und aus einem inneren Jochteil 17b, dessen Grundfläche ebenfalls eine Kreisfläche aufweist.

Die Magneteinheiten 14,15,16 sind dabei abwechselnd unterschiedlich gepolt, und zwar bilden die dem Target 11 zugekehrten Polflächen bei der Magneteinheit 14 einen Nordpol, bei der Magneteinheit 15 einen Südpol und bei der Magneteinheit 16 wieder einen Nordpol. Dies führt zur Ausbildung zweier magnetischer Tunnel, die um die Achse A-A umlaufend geschlossen sind.

Das innere Jochteil 17b ist in einer Ausnehmung 17c des äußeren Jochteils 17a in Normaleinrichtung zur Hauptebene des Targets 11, d.h. in Richtung der Achse A-A, verstellbar. Zur Verstellung dient eine Verstelleinrichtung 21, durch die das innere Jochteil 17b verschoben werden kann. Zwischen den beiden Jochteilen 17a und 17b besteht eine Gleitführung, die als Hülse 19 ausgebildet ist. Durch Heben und Senken einer Spindel 12 läßt sich mittels der Verstelleinrichtung 21 ein Führungsteil 24 und somit das innere Jochteil 17b aus dem äußeren Jochteil 17a heraus oder in dieses hinein bewegen. Durch die Verstelleinrichtung 21 wird erreicht, daß der magnetische Fluß zwischen dem Magnetjoch 17 und der Magneteinheit 14 gegenüber dem magnetischen Fluß zwischen dem gleichen Magnetjoch 17 und den übrigen Magneteinheiten 15,16 verändert wird. Der magnetische Fluß zwischen den Magneteinheiten 15,16 bleibt hiervon jedenfalls im wesentlichen unbeeinflußt. Diese Maßnahme führt dazu, daß die magnetische Feldstärke des den einen Tunnel bildenden Magnetfeldes relativ zu der magnetischen Feldstärke des den anderen Tunnel bildenden Magnetfeldes verändert wird. Auf diese Weise lassen sich die Zerstäubungsraten im Bereich der beiden magnetischen Tunnel unabhängig voneinander verändern, womit sich die örtlichen Schichtdicken auf dem Substrat 22 gezielt beeinflussen lassen.

Die Verstelleinrichtung 21 ist gemäß Ausführungsbeispiel als Stellmotor bzw. als Schrittmotor 10 ausgebildet. Dieser weist einen Rotor auf, der mit der Spindel 12 zusammenwirkt, die ihrerseits mit einer mittleren Partie 20 versehen ist, die als Sechskant ausgebildet ist und in einer Buchse 23 mit zentralem Sechskantloch geführt ist.

Wenn nun der Schrittmotor 10 entsprechend angesteuert wird, verschiebt sich die Spindel 12 je nach Motordrehrichtung längs der vertikalen Achse A-A auf- und abwärts. Die zentrale Magneteinheit 14 ist mit dem inneren Jochteil 17b und das Jochteil 17b seinerseits mit dem Führungsteil 24 verbunden, das in der Hülse 19 gelagert und mit der Spindel 12 fest verbunden ist. Hierdurch kann die Magneteinheit 14 um ein genau kontrollierbares Maß, z.B. gegen die Kraft einer Druckfeder 25, verschoben werden, die sich einerseits an einem den Schrittmotor 10 tragenden Sockelteil 26 und andererseits an einem in einer Bohrung 27 des Sockelteils 26 geführten Führungsteil 24 abstützt.

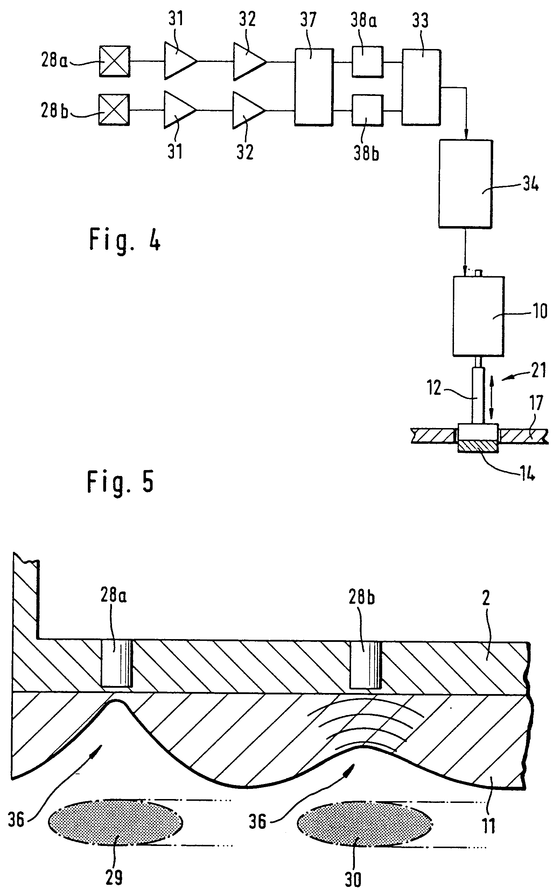

Im Boden des Grundkörpers 2 (Figur 1,5) der Kathode, und zwar in der Stirnplatte 6, sind zwei akustische Sensoren 28a und 28b ortsfest so angeordnet, daß sie nach dem Bonden des Targets 11 idealerweise mit diesem in direktem Kontakt sind. Wird nun in die evakuierte Beschichtungskammer ein Prozeß-Gas (z.B. Argon) eingelassen und steht dabei die Kathode unter Spannung, dann bilden sich im Bereich des magnetischen Tunnel zwei Plasmaringe 29,30 aus. Den Bereich zwischen dem unteren Ende des akustischen Sensors 28a,28b bezeichnet man als Schallvorlaufstrecke 28c.

Durch die erfindungsgemäße Anordnung der beiden akustischen Sensoren 28a,28b in dem topfartigen Grundkörper 2 gemäß Figur 1 und insbesondere gemäß Figur 5 lassen sich auf vorteilhafte Weise die in den Erosionsgräben 36 des Targets 11 erzeugten akustischen Signale erfassen, deren einzelne Werte miteinander verglichen bzw. ausgewertet werden. Über den Rechner 33 wird dann eine Stellgröße für die Verstelleinrichtung 21 zur Verstellung der Magneteinheit 14 ermittelt. Durch die Anordnung der Sensoren in unmittelbarer Nähe des inneren (Sensor 28a) bzw. des äußeren (Sensor 28b) Erosionsgrabens ist ein direkter Rückschluß auf die entsprechenden lokalen Sputterraten möglich, die für die Einstellung der Magneteinheit 14 im wesentlichen relevant sind.

Wie aus Figur 4 hervorgeht, ist der akustische Sensor 28a über einen Vorverstärker 31 und der akustische Sensor 28b über einen Hauptverstärker 32, einen Hochpaßfilter 37 sowie ein RMS Voltmeter 38a,38b an einen Rechner 33 angeschlossen.

Die an einem Hauptverstärker 32 anstehenden Signale werden dabei mittels eines A/D-Wandlers vom Rechner 33 aufgenommen, ausgewertet und dann an die Schrittmotoransteuerung 34 weitergegeben, die ihrerseits mit dem Aktuator bzw. dem Schrittmotor 10 verbunden ist. Somit läßt sich eine optimale Einstellung der Magneteinheit 14 durchführen.

Eine weitere Möglichkeit der Meßwerterfassung besteht darin, einzelne Schallerzeugnisse bezüglich Koinzidenz über Laufzeitmessungen zu erfassen.

Es ist auch möglich, nur mit einem Sensor zu arbeiten. In diesem Fall wird die Aufnahme an elektrischer Leistung der gesamten Kathode in Relation gesetzt zur Leistungsaufnahme eines der beiden Plasmaringe, die sich indirekt aus der Messung des Ultraschalls bestimmen läßt, der innerhalb dieses Plasmarings erzeugt wird. Auch daraus ergibt sich die erforderliche Steuerungsgröße für die Magneten. Aufgrund der ermittelten Meßergebnisse kann die Intensität der Plasmaringe so gesteuert werden, daß eine gleichmäßige Schichtdicke erzielt wird.

Bezugszeichenliste

1
Zerstäubungskathode
2
topfförmiger Grundkörper
3
umlaufender Flansch
4
Isolierstoffkörper
5
Wand
6
Stirnplatte
7
Kühlwasserkanal
8
Kühlwasserkanal
9
Kühlwasserkanal
10
Elektromotor bzw. Schrittmotor
11
Target

12
Spindel
13
Magnetsystem
14
zentrale Magneteinheit
15
Magneteinheit
16
Magneteinheit
17
Magnetjoch
17a
äußeres Jochteil
17b
inneres Jochteil
17c
Ausnehmung des äußeren Jochteils
19
Hülse
20
mittlere Partie der Spindel
21
Verstelleinrichtung
22
Substrat
23
Buchse mit zentralem Sechskantloch
24
Führungsteil
25
Druckfeder
26
Sockelteil
27
Bohrung
28a
akustischer Sensor
28b
akustischer Sensor
28c
Schallvorlaufstrecke
29
äußerer Plasmaring
30
innerer Plasmaring
31
Vorverstärker
32
Hauptverstärker
33
Rechner
34
Schrittmotoransteuerung
35
Vakuumkammer
36
Erosionsgraben

37
Hochpaßfilter
38a,b
RMS Voltmeter
10,14,28,32,33,34
Regelkreis
32,33,34
Schaltkreis

**Patentansprüche**

1. Zerstäubungskathode nach dem Magnetron-Prinzip bestehend aus einem mindestens einteiligen Target (11) und einem hinter dem Target (11) angeordneten Magnetsystem mit mehreren ineinanderliegenden und in sich geschlossenen Magneteinheiten (14,15,16) abwechselnd unterschiedlicher Polung, durch die mindestens zwei gleichfalls in sich geschlossene, ineinanderliegende magnetische Tunnel aus bogenförmig gekrümmten Feldlinien gebildet werden, wobei die dem Target (11) abgekehrten Pole der Magneteinheiten (14,15,16) über ein Magnetjoch (17a,17b) miteinander verbunden sind und die magnetische Feldstärke mindestens eines dieser magnetischen Tunnel relativ zu der magnetischen Feldstärke der übrigen magnetischen Tunnel über Verschieben eines der Jochteile (17b) in bezug auf die anderen Jochteile (17a) über eine Verstelleinrichtung (21) veränderbar ist, **dadurch gekennzeichnet**, daß die Verstelleinrichtung (21) über einen elektrischen Schaltkreis (32,33,34) ansteuerbar ist, der mit mindestens einem hinter dem Target angeordneten, akustischen Sensor (28) zusammenwirkt, der auf mindestens einen der beim Beschichtungsvorgang entstehenden Erosionsgräben (36) des Targets (11) ausgerichtet ist und auf die dort beim und durch das Sputtern erzeugten Ultraschallwellen anspricht, die nach Auswertung in einem Rechner (33) der Verstelleinrichtung (21) als Stellgröße zur Verfügung gestellt werden.

2. Zerstäubungskathode nach Anspruch 1, **dadurch gekennzeichnet**, daß über einen akustischen Sensor (28a,oder 28b) die gemittelte Ultraschallintensität des radial äußeren bzw. inneren Erosionsgrabens (36) gemessen wird, wobei mit dem vom Sensor (28a,oder 28b) kommenden Signal bei gegebener Gesamtleistung der Kathode das Leistungsverhältnis des einen Plasmarings (29) zu dem des anderen Plasmarings (30) vom Schaltkreis (32,33,34) bestimmt, die Abweichung dieses Verhältnisses von einem vorgegebenen Sollwert festgestellt und aus dieser Regelabweichung eine entsprechende Stellgröße an die mit dem Stellmotor (10) zusammenwirkende Motoransteuerung (34) geleitet wird, um die Regelabweichung zu kompensieren.

3. Zerstäubungskathode nach den Ansprüchen 1 und 2, **dadurch gekennzeichnet**, daß über einen ersten akustischen Sensor (28b) der gemittelte Ultraschall des radial äußeren Erosionsgrabens (36) gemessen wird und der gemittelte Ultraschall des inneren Erosionsgrabens über einen zweiten Sensor (28a) gemessen wird, wobei im Schaltkreis (32,33,34) das Verhältnis der Sputterraten der beiden Erosionsgräben bestimmt, die Abweichung dieses Verhältnisses von einem vorgegebenen Sollwert festgestellt und aus dieser Regelabweichung eine entsprechende Stellgröße festgelegt und dem Stellmotor (10) zugeleitet wird.

4. Zerstäubungskathode nach den Ansprüchen 1 bis 3, **dadurch gekennzeichnet**, daß mit den verwandelten akustischen Sensoren (28a,28b) durch Verwendung von Frequenzfiltern ein schmales Frequenzband des erzeugten Ultraschalls vermessen wird, um das Signal-Rausch-Verhältnis zu verbessern.

5. Zerstäubungskathode nach den Ansprüchen 1 bis 3, **dadurch gekennzeichnet**, daß die Fokussierungseigenschaften des auf einen bestimmten Erosionsgraben (36) gerichteten akustischen Sensors (28a, 28b) durch Einbau einer Schallvorlaufstrecke (28c) verbessert werden, wobei diese Vorlaufstrecke ein aus dem Material des Grundkörpers (2) bestehender zylinderförmiger Stab ist, der zusätzlich von einer Dämpfungsschicht umgeben ist.

6. Zerstäubungskathode nach den Ansprüchen 1 bis 3 **dadurch gekennzeichnet**, daß das Target (11) im Bereich zwischen den Erosionsgräben eine konzentrische Nut besitzt, durch die eine weitere Entkopplung des in den einzelnen Erosionsgräben entstehenden Ultraschalls erreicht wird.

7. Zerstäubungskathode nach Anspruch 1, **dadurch gekennzeichnet**, daß mit mindestens zwei hinter dem Target angeordneten akustischen Sensoren (28a,28b) einzelne Schallereignisse vermessen werden und deren Herkunft aus einem der Erosionsgräben mit Hilfe der Laufzeit bestimmt wird, so daß durch Zählung der Häufigkeit der Ereignisse die Sputterintensität in den einzelnen Erosionsgräben und deren Verhältnis berechnet und schließlich mittels des Regelkreises dem Stellmotor als Stellgröße zugeführt werden kann.

8. Zerstäubungskathoden nach den vorangegangenen Ansprüchen **dadurch gekennzeichnet**, daß die Auswertung der Signale und die eigentliche Regelung der Dickenhomogenität mit Hilfe einer Verstellung der verschiedenen Jochteile miteinander durch einen digitalen Rechner vorgenommen wird und der im Rechner benutzte digitale Regler im allgemeinen Fall als Regler höherer Ordnung realisiert ist.

9. Zerstäubungskathode nach den Ansprüchen 1, 2, und 3, **dadurch gekennzeichnet**, daß der Rotor des über den Schaltkreis (32, 33, 34) mit den akustischen Sensoren (28a,28b) zusammenwirkenden Stellmotors (10) mit einer gegen Drehen gesicherten Spindel (12) zusammenwirkt, deren eines Ende mittels des inneren Jochteils (17a) mit der Magneteinheit (14) fest verbunden ist und deren anderes Ende von einer Spindelhülse geführt wird, die vom Rotor des Stellmotors (10) gedreht wird und deren Abstand vom Magnetjoch (17) über den Sockel (26) festgelegt ist.

10. Zerstäubungskathoden nach den vorangegangenen Ansprüchen, **dadurch gekennzeichnet**, daß im Fall von mehr als zwei Erosionsgräben (36) und einer vorgesehenen gegenseitigen Verstellbarkeit der entsprechenden Jochteile (17a,17b) die Sputterintensität der einzelnen Erosionsgräben (36) mittels zwei oder mehrerer akustischer Sensoren (28a,28b) über den erzeugten Ultraschall vermessen wird und die Einstellung einer optimalen Schichtdickenhomogenität durch Verstellen der Jochteile (28a,28b) im Rahmen eines Regelkreises realisiert wird, der diese akustischen Signale verwendet, um die notwendigen Stellgrößen festzustellen.

Fig. 1

Fig. 2

Fig. 3

Fig. 4

Fig. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,Y | EP-A-0 337 012 (LEYBOLD) <br> * Zusammenfassung * <br> * Ansprüche 1,2 * <br> * Abbildungen 1-5 * <br> --- | 1-10 | H01J37/34 |
| D,Y | MICROELECTRONIC MANUFACTORING AND TESTING November 1985, Seiten 32 – 34; A.B. CISTOLA: 'Using Acoustic Emission to Determine Dynamic Sputter Target Performance' * das ganze Dokument * <br> ----- | 1-10 | |
| | | | **RECHERCHIERTE SACHGEBIETE (Int. Cl.5)** <br><br> H01J |

Der vorliegende Recherchenbericht wurde für alle Patentansprüche erstellt

| Recherchenort | Abschlußdatum der Recherche | Prüfer |
|---|---|---|
| DEN HAAG | 15 APRIL 1992 | DAMAN M.A. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
......................................................................
& : Mitglied der gleichen Patentfamilie, übereinstimmendes
    Dokument